# EUROPEAN PATENT APPLICATION

(11) **EP 4 657 006 A1**
(43) Date of publication of application: **03.12.2025**
(21) Application number: 24305849.2
(22) Date of filing: 29.05.2024
(51) Int. Cl.: G01B 7/02

(54) **EDDY CURRENT SENSOR**

(71) Applicant: Ratier-Figeac SAS, 46101 Figeac Cedex (FR)
(72) Inventor: AUBARET, Yohann, Capdenac (FR)
(74) Representative: Dehns

(57) **Abstract**

An eddy-current sensor (1) includes an electrically conductive coil (4), an electrically conductive casing (18) and a separator (16) formed from non-magnetic material. The eddy-current sensor (1) is arranged to sense a distance between the electrically conductive coil (4) and an outer surface of an electrically conductive target (2), the electrically conductive target (2) separated from the electrically conductive coil (4) along a target spacing direction (14). The separator (16) is interposed between the electrically conductive coil (4) and the electrically conductive casing (18). The electrically conductive casing (18) comprises a first portion (20), positioned outwards of the electrically conductive coil (4) along the target spacing direction (14) and extending perpendicular to the target spacing direction (14), and a second portion (22a, 22b), extending from the first portion (20) along the target spacing direction (14) past at least part of the electrically conductive coil (4), so as to focus a magnetic field produced by the electrically conductive coil (4) along the target spacing direction (14).

## Description

### Technical field

This disclosure relates to an eddy current sensor and a method of constructing an eddy-current sensor.

### Background

It is known to sense distance or proximity to an electrically conductive target using an eddy-current sensor.

It is known to provide eddy-current sensors with a laminated ferromagnetic core, in order to reduce the induction of eddy-currents in the core by the coil of the sensor, and thereby reduce attenuation of the magnetic field as a result of these eddy-currents, and also to provide magnetic shielding to reduce magnetic pollution around the sensor. However, laminated cores are expensive and therefore drive up manufacturing costs, and ferromagnetic materials are generally more expensive than non-ferromagnetic materials.

The present disclosure seeks to provide an improved eddy-current sensor which addresses at least some of these shortcomings.

### Summary

According to a first aspect of this disclosure there is provided an eddy-current sensor comprising:
an electrically conductive coil, wherein the eddy-current sensor is arranged to sense a distance between the electrically conductive coil and an outer surface of an electrically conductive target, the electrically conductive target separated from the electrically conductive coil along a target spacing direction;
an electrically conductive casing; and
a separator formed from non-magnetic material;
wherein the separator is interposed between the electrically conductive coil and the electrically conductive casing; and
wherein the electrically conductive casing comprises a first portion, positioned outwards of the electrically conductive coil along the target spacing direction and extending perpendicular to the target spacing direction, and a second portion, extending from the first portion along the target spacing direction past at least part of the electrically conductive coil, so as to focus a magnetic field produced by the electrically conductive coil along the target spacing direction.

It will be understood that an eddy-current sensor generally is a sensor which senses distance or proximity of an electrically conductive target based on the phenomenon of eddy current production. An electrically conductive coil of the eddy-current sensor is driven with an alternating current, which causes the electrically conductive coil to produce a time-varying magnetic field. When a conductive target passes through this magnetic field, according to Faraday's law of induction, the magnetic field induces alternating electric currents in the surface of the conductive target. These induced surface currents are known as eddy currents. The eddy currents self-produce another magnetic field, which affects the impedance of the sensor coil. The change in impedance of the sensor coil due to the eddy currents in the conductive target is directly linked to the distance (e.g. air gap) between the sensor coil and the conductive target. Thus, the distance can be obtained by measuring the equivalent impedance.

The first portion of the casing is positioned outwards of (i.e. further from) the electrically conductive coil along the target spacing direction, by this it will be understood that the first portion is further away from the target along the target spacing direction than the electrically conductive coil, i.e. it is distal from the target along the target spacing direction, it is positioned on the opposite side of the electrically conductive coil from the target. The first portion may be planar. The plane of the planar first portion may be perpendicular to the target spacing direction. For example, the first portion may be a flat plane, perpendicular to a single target spacing direction (i.e. in the case of a cylindrical eddy-current sensor, where the target spacing direction is parallel to the central axis of the cylinder). Alternatively, as explained below, the target spacing direction may be a radially inwards direction of the coil. The first portion may be a curved plane (i.e. a flat ring), such that at all points around the curved plane it is perpendicular to the radial direction of the coil, and therefore to the target spacing direction.

The second portion extends along the target spacing direction. By this it will be understood that the second portion extends towards the electrically conductive target. The second portion thus extends at an acute angle to the target spacing direction, such that a component of its direction is towards the target spacing direction. In some examples the second portion extends (substantially) parallel to the target spacing direction (i.e. perpendicular to the first portion). The second portion extends from the first portion, which is outwards of the coil (i.e. further out from the target) along the target spacing direction (i.e. towards the target). In doing so it extends past at least part of the coil, meaning that it extends through a distance along the target spacing direction (i.e. a distance away from the target) that is equal to a distance along the target spacing direction at which the coil is present (i.e. it extends level with at least a part of the coil along the target spacing direction). In other words, a part of the second portion is next to a part of the coil, such that both are substantially the same distance away from the target. In some examples, the second portion extends past the coil (i.e. beyond the coil along the target spacing direction). Thus, it extends past the entire (axial length of the) coil.

Thus, the electrically conductive casing extends around the coil, such that it extends around an outer side of the coil (the part which is distal from the target) and it extends around the "sides" of the coil. This allows the casing to focus the magnetic field produced by the coil towards the target, i.e. along the target spacing direction, improving sensitivity of the eddy-current sensor and reducing magnetic pollution produced by the eddy-current sensor, by reducing the magnetic field in directions away from the target.

The casing focusses (i.e. canalizes) the magnetic field along the target spacing direction. By this it is meant that the magnetic field produced by the electrically conductive coil is directed to extend along the target spacing direction towards the target, and that it is not directed to extend away from (or outside of) the eddy-current sensor in other directions (i.e. radially outwards or axially sideways). It will be understood that focussing the magnetic field therefore refers to generally directing it, and does not require that the field is focussed to a single point.

By arranging the electrically conductive coil within an electrically conductive casing, focussing of the produced magnetic field towards the target is achieved, improving the sensitivity of the eddy-current sensor. By separating the electrically conductive coil from the casing using the separator, the magnetic field strength at the casing is reduced by virtue of it being further away from the electrically conductive coil. This reduces the magnetic field attenuation caused by eddy currents induced in the casing and thereby reduces the performance drop that they cause, particularly at high frequencies. This reduction in attenuation also makes it more feasible to use the induced eddy currents for focussing, since they would otherwise be so large as to reduce sensitivity of the sensor.

The disclosed structure therefore advantageously focusses the magnetic field towards the electrically conductive target by virtue of the provided electrically conductive casing, whilst also avoiding significant performance drop due to this casing, particularly at high frequencies. This is also achieved in a simple and low-cost manner, since it does not require a laminated material for the casing (which is another possibility for reducing eddy currents in the casing) and it does not require a ferromagnetic material for the casing (which is more expensive), rather any electrically conductive material may be used. A ferromagnetic material is not required since usually the ferromagnetic material acts like a magnetic shield to the sensor, and prevents (or reduces) magnetic pollution around the sensor, but in this case this shielding effect is provided by the opposite magnetic fields produced by the eddy currents induced in the electrically conductive casing.

It will be understood that a coil (i.e. a linear coil, having a straight central axis) generally has a circular or cylindrical form. Both a circle and a cylinder define a central axis, perpendicular to the circular face of either shape. An axial direction of the coil will be understood as the direction parallel to this central axis. Whether the coil is considered as having a circular or a cylindrical shape depends on how far along this axial direction it extends. A radial direction of the coil (i.e. of the circle or cylinder) will be understood as a direction pointing along a radius of the circle of the coil (i.e. towards or away from the central axis, in the plane of the circular face), i.e. perpendicular to the curved path of the circle. It will be appreciated that in practice the coil need not be precisely circular in order for these terms to be meaningfully understood.

Thus, the casing may alternatively be understood as comprising an axial portion, extending along the axial direction of the coil, and a radial portion, extending radially inwards. In some examples, the axial portion provides the first portion, and the radial portion provides the second portion. Thus, in such examples, the target spacing direction is the radial direction, i.e. the coil senses an electrically conductive target located within the coil.

In other examples, the radial portion provides the first portion and the axial portion provides the second portion. In such examples, the target spacing direction is the axial direction, i.e. the coil senses a target located axially below (i.e. downwards, outside) the coil.

Thus, in some examples, the target spacing direction is a radial (i.e. radially inwards) direction of the electrically conductive coil, such that the eddy-current sensor is arranged to sense a distance between the electrically conductive coil and the outer surface of an electrically conductive target located within the electrically conductive coil. Thus, in some examples, the first portion extends circumferentially around the electrically conductive coil (i.e. around a radially outer edge), e.g. forming a planar ring as described above. In some examples, the second portion extends along the radial direction, i.e. perpendicular to the axial direction, towards the target. In some examples the eddy-current sensor is a ring-shaped eddy-current sensor.

In some examples, the electrically conductive coil comprises at least one turn (e.g. loop of conductive wire). The turn may be (substantially) circular. The turn may define the axial direction and the radial direction described above. Thus, the target spacing direction may be along the radial direction of the at least one turn (i.e. inwards towards centre of the turn or loop). Thus, the electrically conductive casing (in particular the first portion) may extend circumferentially around a radially outer edge of the turn, perpendicular to the radial direction. The second portion may extend along the radial direction of the turn (i.e. towards the centre of the turn), past at least part of the radial extend of the coil. The electrically conductive coil may comprise a plurality of turns, wherein a plurality (optionally all) of the turns are arranged coaxially along a central (straight) axis.

In some examples, the electrically conductive casing further comprises a third portion, extending from the first portion (generally or substantially) along the target spacing direction past at least part of the electrically conductive coil, on an opposite side of the electrically conductive coil to the second portion. By the second and third portions being located on opposite sides of the electrically conductive coil it will be understood that there is an axis passing through both the second and third portions and along this axis the electrically conductive coil is located between them. The second and third portions may be opposite each other along an axis perpendicular to the target spacing direction. They may be located opposite each other along the axial direction of the coil.

In some other examples, the target spacing direction is an axial (i.e. axially downwards) direction of the electrically conductive coil, i.e. such that the eddy-current sensor is arranged to sense a distance between the electrically conductive coil and the outer surface of an electrically conductive target located outside of and directly below the electrically conductive coil. In some examples, the second portion is (substantially) cylindrical, and the at least part of the electrically conductive coil is accommodated within the cylindrical second portion. Thus, the eddy-current sensor may be a cylindrical eddy-current sensor (i.e. extending parallel to a central cylindrical axis). The target spacing direction may be parallel to the central axis of the cylindrical second portion. Thus, the target may be located, in use, on one side of the electrically conductive coil. Thus, the first portion may be positioned on an opposite side of the coil to the target. The first portion may extend perpendicular to the central axis of the cylindrical second portion.

The electrically conductive casing may also be referred to as a core. The electrically conductive casing may provide an outer housing of the eddy-current sensor. Thus, for example, the first portion may provide a circumferentially outer portion of the housing of the eddy-current sensor and the second portion (and optionally third portion) may provide axially outer portions of the housing. Alternatively, the first portion may provide an axially end portion of the housing of the eddy-current sensor, and the second portion may provide a cylindrical side portion of the eddy-current sensor.

The casing thus extends around (e.g. surrounds) the electrically conductive coil in all directions other than the target spacing direction. This helps to improve the focussing effect on the magnetic field that is provided by the electrically conductive casing.

In some examples, the electrically conductive casing is formed from non-ferromagnetic material.

In some examples the electrically conductive casing comprises (e.g. is made of, formed from or consists of) aluminium. This is a low cost and readily available material, which is able to fulfil the function of the electrically conductive casing.

The separator is interposed between the electrically conductive coil and the electrically conductive casing. By this it is meant that the separator separates the coil and the casing along at least one direction, i.e. there is at least one position at which the separator is located between the coil and the casing. The separator need not be interposed between the coil and the casing at all positions, i.e. along all directions. Thus, there may be some contact between the coil and the casing, or, preferably, there may be no contact between the coil and the casing. In that case, the separator may surround the coil (i.e. so as to separate it from the casing on all sides, as described below), or the separation may be achieved in some manner other than with the separator, i.e. by providing an air-gap, or by providing one or more secondary separators.

In some examples, the separator is interposed between the first portion of the electrically conductive casing and the electrically conductive coil. Thus, moving along the target spacing direction outwards from the target (or moving along the radial direction), the separator is located after (i.e. outwards of) the coil, and inwards of the first portion of the casing. This does not restrict there being other components in front of the coil (i.e. closer to the target) or outside of the casing. Alternatively, in other examples, an air gap may be provided between the first portion of the electrically conductive casing and the electrically conductive coil.

In some examples, the separator is interposed between the second portion of the electrically conductive casing and the electrically conductive coil. Thus, moving perpendicular to the target spacing direction (or moving along the axial direction, parallel to the central axis), the separator is located after the coil and before the casing (or this may be the opposite, depending on the direction of movement along the axial direction).

In some examples, the separator is interposed between the third portion of the electrically conductive casing and the electrically conductive coil. The thickness of the separator between the second portion and the coil may be equal to the thickness of the separator between the third portion and the coil. This advantageously provides a balanced effect on the magnetic field on either side of the coil.

In some examples, the separator comprises an inner separator portion, positioned inwards of the electrically conductive coil along the target spacing direction (e.g. positioned radially inwards of the electrically conductive coil). Thus, in use this inner separator portion is located between the electrically conductive coil and the electrically conductive target. This inner separator portion may help to retain the electrically conductive coil in position.

In some examples, the electrically conductive coil is surrounded by the separator. Thus, the electrically conductive coil may be encased (i.e. encircled) on all sides by the separator. This helps to ensure that a desired spacing between the separator and the electrically conductive coil is achieved at all parts of the coil.

In some examples, the electrically conductive casing defines a hollow, wherein the hollow is filled by the combination of the separator and the electrically conductive coil. This advantageously provides an eddy-current sensor which does not require any additional separators, or for any air-gaps to be created.

In some examples, the thickness of the separator interposed between the electrically conductive coil and the electrically conductive casing is at least 3 mm, optionally at least 4 mm, further optionally at least (or approximately) 5 mm, further optionally at least (or approximately) 6 mm. It will be understood that the separator may have different thicknesses in different parts, and that therefore where the thickness is referred to this may be the minimum thickness throughout the separator, or may be the thickness between the coil and a particular one of the portions of the casing mentioned above. A thickness of at least 4 mm provides a desirable amount of reduction in the attenuation of the magnetic field, particularly at high frequencies.

In some examples, the thickness of the separator interposed between the electrically conductive coil and the electrically conductive casing may be equal to or less than 6 mm. This helps to ensure that the magnitude of the eddy currents isn't reduced too far, since this would reduce the focussing effect achieved by the casing.

In some examples, the thickness of the inner separator portion (i.e. along the target spacing direction/the radial direction) is smaller than the thickness of the portion interposed between the coil and the first portion and/or the second portion and/or the third portion. This smaller thickness ensures that the coil is able to be relatively close to the target.

In some examples, the thickness of the separator between the coil and the second portion and/or the third portion of the casing (i.e. perpendicular to the target spacing direction or parallel to the axial direction) is smaller than the thickness of the separator between the coil and the first portion (i.e. along the target spacing direction or parallel to the radial direction). This provides a greater reduction in attenuation of the magnetic field behind the coil (i.e. radially outwards) than axially outwards. This is advantageous since the magnetic field is generally stronger in the radial direction (both inwards and outwards) due to the shape of the coil, and so if the thickness of the separator were the same in both directions, greater attenuation would be caused by the first portion of the casing.

The separator is formed from non-magnetic material. It may be formed from a single non-magnetic material, or from more than one non-magnetic material. In some examples the separator comprises (e.g. is made of, consists of) polymer material (e.g. a plastic polymer), for example polyvinyl chloride (PVC) and/or polyether ether ketone (PEEK).

In some examples, the eddy-current sensor further comprises an oscillator arranged to supply alternating current to the electrically conductive coil (i.e. such that the coil produces a time-varying magnetic field). The supplied alternating current may be a sinusoidal signal. As explained above, this induces alternating electric currents (eddy currents) in the electrically conductive target which in turn produce their own magnetic fields, which affect the impedance of the electrically conductive coil, a change which is detected and used to sense the distance between the electrically conductive coil and the surface of the target.

In some examples, the oscillator is arranged to supply alternating current to the electrically conductive coil having a frequency of at least (or approximately) 500 kHz, optionally at least (or approximately) 750 kHz, further optionally at least (or approximately) 1 MHz. It is an advantage of the described eddy-current sensor design that it is able to operate at these high frequencies without significant reduction in the sensitivity of the sensor.

It will be understood that the disclosure further extends to a system, comprising an eddy-current sensor as described above, and an electrically conductive target, positioned for sensing by the eddy-current sensor. The electrically conductive coil may be positioned around the target, i.e. it may extend circumferentially around the target. The target may be arranged to pass through an opening in the eddy-current sensor. The target may be elongate, defining an elongate axis. The target may be positioned such that its elongate axis (substantially) aligns with the central axis of the electrically conductive coil.

The present disclosure further extends to a method of constructing an eddy-current sensor. Therefore, according to a second aspect there is provided a method of constructing an eddy-current sensor, comprising:
forming a piece of non-magnetic material;
wrapping an electrically conductive wire onto the piece, to form the electrically conductive coil;
wherein the separator comprises the piece and wherein the method further comprises:
   forming the electrically conductive casing around the separator and the electrically conductive coil, such that the separator is interposed between the electrically conductive coil and the electrically conductive casing.

The eddy-current sensor constructed by this method may have any of the features as described above. Similarly, the method may further comprise forming any of the structural features as described above. Thus, forming the electrically conductive casing may further comprise forming a first portion, positioned outwards of the electrically conductive coil along the target spacing direction and extending perpendicular to the target spacing direction, and forming a second portion, extending along the target spacing direction.

The electrically conductive wire is wound onto the piece, and the piece forms at least a part of the separator. By this it will be understood that wire is formed into its coil shape (e.g. turns or loops) whilst supported in some way by the piece (i.e. by a part of the separator). Any suitable method may be used. The wire may be externally wound i.e. around the piece (e.g. wrapped around a cylinder of non-magnetic material), or may be internally wound, e.g. within a circular shape defined within the piece. Further alternatively the piece may be a flat piece (e.g. a sheet) of non-magnetic material defining a plane onto which the wire is coiled (i.e. with its axial direction perpendicular to the sheet).

This is advantageous since a part of the separator (optionally the separator itself) conveniently provides a structure which assists with forming the electrically conductive coil, thus improving the ease of manufacture of the eddy-current sensor.

In some examples the piece is the separator, i.e. the whole separator is formed initially, and the wire is wound onto this. In other examples, the piece forms part of the separator, and the method further comprises (i.e. after wrapping the wire) forming a second piece of non-magnetic material, and connecting the (first) piece to the second piece to form the separator.

### Detailed description

Certain preferred examples of this disclosure will now be described, by way of example only, with reference to the accompanying drawings, in which:
Figure 1 is a cross-sectional view showing the magnetic field produced by an eddy-current sensor according to the prior art;
Figure 2 is a cutaway side view showing an eddy-current sensor according to a first example of the present disclosure, positioned around a target;
Figure 3 is a cross-sectional view of the components of Figure 2, taken perpendicular to the centre axis of the target;
Figure 4 is a cross-sectional view of the eddy-current sensor of Figure 3, taken along the line A indicated in Figure 3;
Figure 5 is a view showing the right-hand part of the view of Figure 4, illustrating the magnetic field produced by the electrically conductive coil;
Figure 6 is a cross-sectional view of the eddy-current sensor of Figure 3, taken along the line A indicated in Figure 3, illustrating the magnetic field produced both by the electrically conductive coil, and by the electrically conductive casing;
Figure 7 is a flow diagram representing a method of constructing an eddy-current sensor as shown in Figure 2;
Figure 8 is a cutaway side view showing an eddy-current sensor according to a second example of the present disclosure, positioned above a target; and
Figure 9 is a schematic diagram showing a cross-sectional view of a sensor apparatus using two eddy-current sensors according to the present disclosure.

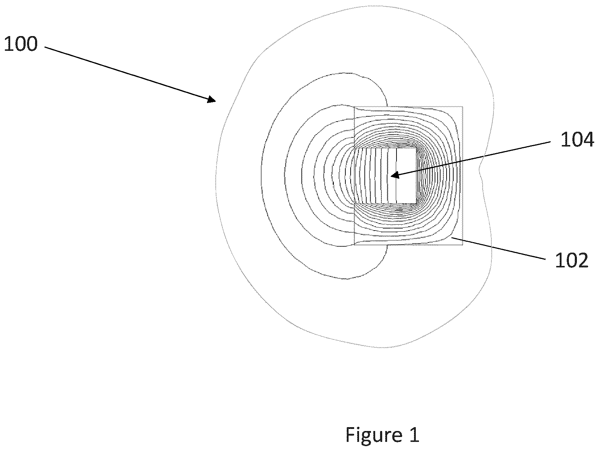

Figure 1 illustrates the magnetic field 100 produced by an electrically conductive coil 104 wrapped directly around a ferromagnetic core 102. It can be seen that there is high magnetic pollution in this arrangement since the magnetic field extends to the sides and behind the ferromagnetic core 102, as well as in the sensing direction (to the left in the view of Figure 1). It can also be seen that large eddy-currents are induced in the ferromagnetic core 102, which attenuate the magnetic field 100. These features are disadvantageous.

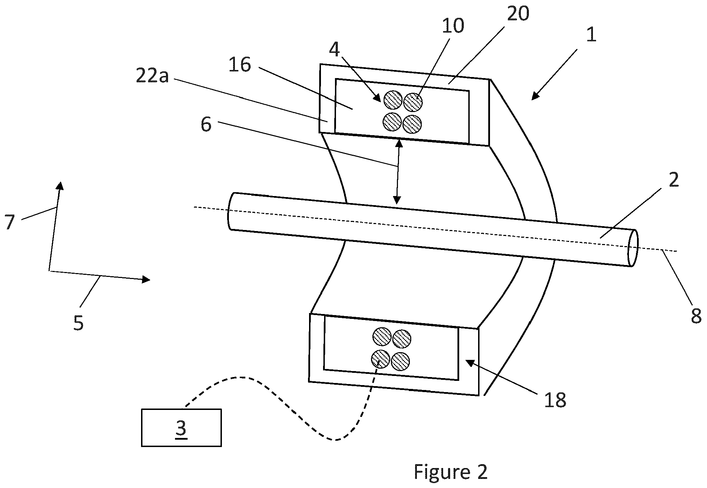

Figure 2 is a cutaway side view showing an eddy-current sensor 1. The eddy-current sensor 1 is arranged around a target 2. The target 2 is electrically conductive.

The eddy-current sensor 1 includes an electrically conductive coil 4 (also referred to as an electromagnetic coil or an inductor) which is driven by an oscillator 3 (as represented schematically in Figure 2). Driving the electrically conductive coil 4 with an alternating current produces a time-varying magnetic field, as described in greater detail below.

The general operating principal of the eddy-current sensor 1 is that when the electrically conductive target 2 passes through the magnetic field generated by the electrically conductive coil 4, according to Faraday's law of induction, the magnetic field induces alternating electric currents in the surface of the electrically conductive target 2. These induced surface currents are known as eddy currents. The eddy currents self-produce another magnetic field, which affects the impedance of the electrically conductive coil 4. The change in impedance of the electrically conductive coil 4 due to the eddy currents in the conductive target is directly linked to the separation distance 6 (e.g. air gap) between the electrically conductive coil 4 and the conductive target 2. Thus, the distance 6 between the electrically conductive coil 4 and the conductive target 2 can be obtained by measuring the equivalent impedance. This allows eddy-current sensors to function as distance and proximity sensors.

In this example, the eddy-current sensor 1 is ring-shaped (i.e. circular). The ring-shape defines a centre axis 8 which extends perpendicular to the plane of the ring/circle, through the centre of the ring. Only half of the ring is seen in the cutaway view of Figure 2.

The ring-shape defines an axial direction 5, parallel to the centre axis 8 of the ring, and defines a radial direction, extending along a radius of the ring. It will be appreciated that the radial direction encompasses all radii of the ring, so only one radial direction 7 is indicated in Figure 2 for illustrative purposes.

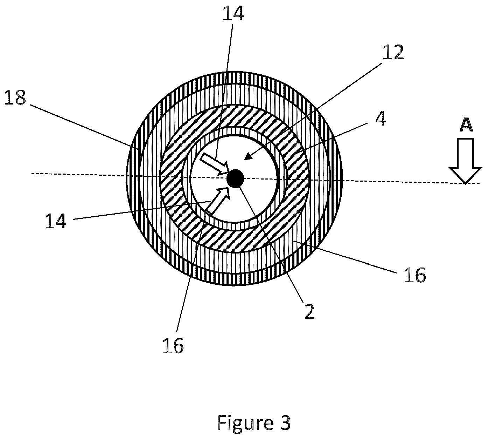

It can be seen that the electrically conductive coil 4 includes several turns 10, which each extend around the ring (i.e. each turn corresponds to one complete loop around the ring-shape, e.g. the circular shape seen as the coil 4 in Figure 3). These turns therefore share the same centre axis 8 as the overall eddy-current sensor 1, and therefore this centre axis 8 may also be referred to as a turn centre axis or a coil axis.

It will be appreciated that the impedance change due to the target 2 occurs throughout the entirety of the electrically conductive coil 4 (i.e. throughout each turn 10). Thus, if the central axis of the target 2 moves off-centre from the centre axis 8 of the electrically conductive coil 4, although this will create a larger impedance change in the area of the coil 4 that the target 2 moves towards, this effect will be balanced by a substantially corresponding reduction in the change of impedance that is detected on the opposing side of the coil 4 (i.e. in the area that the target 2 has moved away from). The ring-shaped eddy-current sensor 1 is therefore relatively insensitive to movement of the target 2 moving off the centre axis 8 of the electrically conductive coil 4. It will, however, detect changes in the diameter of the target 2 since these will alter the average separation distance 6 between the target 2 and the electrically conductive coil 4, and therefore affect the average impedance change.

Thus, although not illustrated as such, the target 2 may have a varying diameter along its length (i.e. along the axial direction 5). As the target 2 is moved parallel to the centre axis 8 the diameter of the part of the target 2 that is within the eddy-current sensor 1 (i.e. the diameter of the detected target portion) varies, and this variation is detectable using the eddy-current sensor 1 since it changes the average distance between the target 2 and the electrically conductive coil 4. Knowledge of the diameter of the part of the target 2 within the electrically conductive coil 4 is indicative of axial movement of the target portion 2 along the direction of the centre axis (i.e. along the axial direction 5), which may be important in a number of different contexts. This axial movement is detectable using the described ring-shaped eddy current sensor 1.

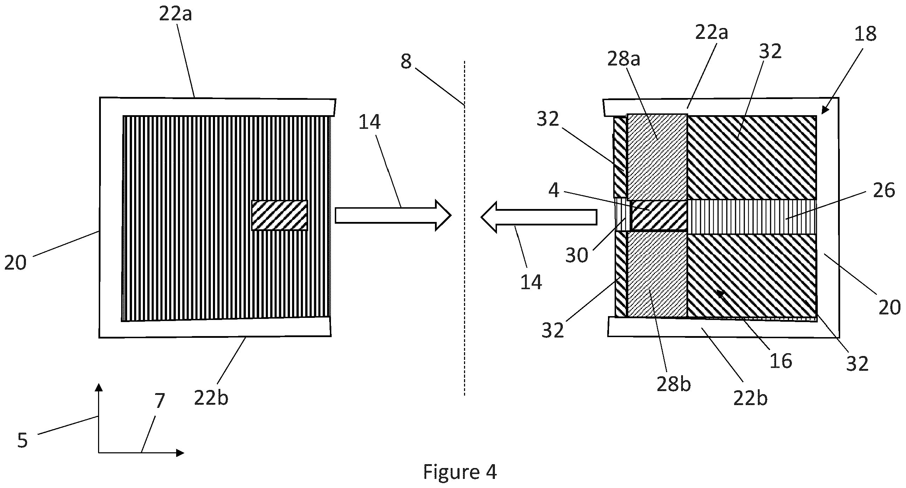

The structure of the eddy-current sensor 1 is shown in greater detail in the cross-sectional view of Figure 3, taken through the eddy-current sensor 1 perpendicular to the centre axis, and in the cross-sectional view of Figure 4, taken along the line A indicated in Figure 3. Although the cross-section of Figure 4 is taken along this line A it will be appreciated that since the eddy-current sensor 1 is rotationally symmetric about the centre axis 8, a slice taken at any angle (not specifically the horizontal line shown) across the view of Figure 3, passing through the centre axis, will provide substantially the same cross-section.

As explained above, the eddy-current sensor 1 is separated from the target 2 by an air-gap 12.

The target 2 is separated from the electrically conductive coil 4 along a target spacing direction 14. In this example of a ring-shaped eddy-current sensor 1, this target spacing direction is the radially inwards direction, i.e. it is not defined by a single axis, but is rather defined by a set of directions, being the directions that are radially inwards of the electrically conductive coil 4. In other examples, e.g. of cylindrical eddy-current sensors, there may be a single target spacing direction defined parallel to a single target spacing axis.

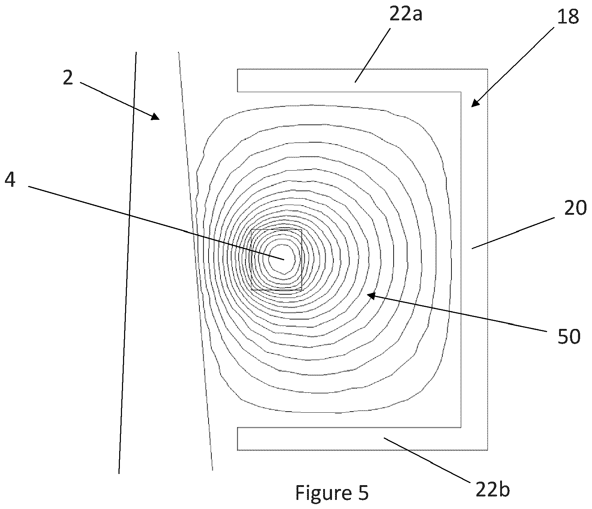

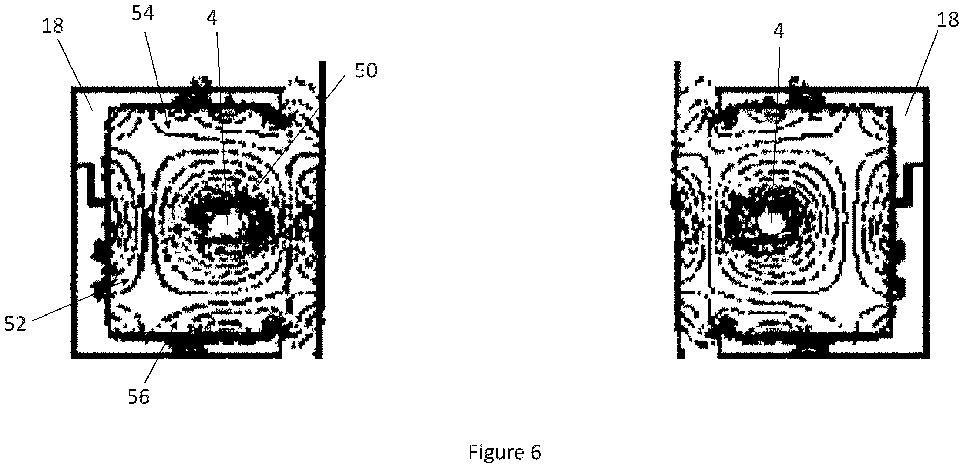

Around both the inside and the outside of the electrically conductive coil 4 (i.e. radially outwards and inwards, with reference to the view of Figure 3) there is positioned a separator 16 (which may also be referred to as a spacer). The separator 16 separates the electrically conductive coil 4 from an electrically conductive casing 18, which surrounds the separator 16. The shape of the separator 16 around the electrically conductive coil 4, according to this particular example, can be seen more clearly in Figure 4. The separator 16 is made of a non-magnetic material. The function of this separator 16 is explained further below with reference to Figures 5 and 6.

The electrically conductive casing 18 has a first, outer portion 20. This first portion 20 extends perpendicular to the target spacing direction 14, and is arranged outwards of the coil 4 (and the separator 16), i.e. distal from the target 2. This first portion 20 has the form of a flat ring, as seen in Figure 2.

The electrically conductive casing 18 further includes a second portion 22a and a third portion 22b, extending substantially parallel to the target spacing direction 14 (i.e. radially inwards towards the target 2). They extend either side of the coil 4, each forming a planar ring, with the plane of the ring parallel to the plane of the coil turns 10, as seen in Figure 2. As is seen in Figures 2 and 4 the second and third portions 22a, 22b are positioned on opposite sides of the coil 4.

In the first example of Figures the separator 16 surrounds the electrically conductive coil 4, i.e. it extends all the way around the coil 4 on all sides. The separator 16 may be conceptually divided into separate sections which are interposed between different parts of the eddy-current sensor 1, as illustrated in the right-hand part of Figure 4. In practice, the separator may be provided as a single piece, or may be formed from multiple pieces, but these pieces need not correspond to the indicated parts. The separator 16 includes a first part 26, which is interposed between the coil 4 and the first (outer) portion 20 of the casing. The separator 16 also includes second and third parts 28a, 28b, which are interposed between the coil 4, and the respective second and third (side) portions 22a, 22b of the coil 4. The separator 16 also includes a fourth, inner separator portion 30. This portion is positioned between the coil 4 and the target 2, and is therefore inwards of the coil 4 along the target separation direction 14. In this example the inner hollow defined by the casing 18 is filled entirely by the combination of the separator 16 and the coil 4, i.e. there are no air gaps. Thus, conceptually, the separator further comprises a number of filler portions 32. These are interposed diagonally between the coil 4 and various parts of the casing 18.

In other examples, not illustrated, one or more of these sections of the separator 16 may be omitted. An air-gap may be provided between the coil 4 and the casing 18 as an alternative to one or more (but not all) of these sections, e.g. in place of the first part 26.

The advantages of the disclosed eddy-current sensor 1 design may be understood with reference to Figures 5 and 6.

Figure 5 shows the right-hand part of the view of Figure 4 (i.e. to the right of the central axis 8), illustrating the magnetic field produced by the electrically conductive coil 4. Figure 6 shows the same view as Figure 5, and illustrates the magnetic field produced both by the electrically conductive coil 4, and by the electrically conductive casing 18, as explained further below. For clarity, the separator 16 has been omitted in both of these Figures.

In Figure 5 it can be seen that in a plane perpendicular to the coil 4 (i.e. perpendicular to the wire defining the coil, at a given point around the coil) the coil 4 produces an approximately circular magnetic field 50, wrapping around the coil 4. The effect of the casing 18 is to focus (i.e. canalize) the magnetic field 50 produced by the electrically conductive coil 4 towards the electrically conductive target 2, meaning that the magnetic field 50 is directed to extend along the target spacing direction 14 towards the target 2, and that it is not directed to extend away from (or outside of) the eddy-current sensor 1 in other directions (i.e. radially outwards or axially sideways along the axial direction 5). This focussing of the magnetic field 50 in the particular direction towards the target 2 is achieved as explained below with reference to Figure 6.

The magnetic field 50 produced by the electrically conductive coil 4 is time-varying, since the coil is supplied with an AC signal input. This time-varying magnetic field 50 extends to the casing 18, as shown in Figure 5. Where this time-varying magnetic field 50 intersects with the surface of the electrically conductive casing 18, alternating electric currents (known as eddy currents) are induced in the surface of the electrically conductive casing 18, i.e. such that respective time-varying electric currents are induced in the first portion 20, the second portion 22a and the third portion 22b of the casing 18.

These induced eddy currents each self-produce their own respective magnetic fields. The induced eddy current in the first portion 20 induces a corresponding first induced magnetic field 52, and likewise the eddy currents induced in the second portion 22a and the third portion 22b create their own respective magnetic fields 54, 56. These induced magnetic fields 52, 54, 56 oppose the magnetic field 50 that has created them, as illustrated by the magnetic field lines shown in Figure 6. They thus partially or fully cancel out the magnetic field in the regions close to and within the casing 18, such that little or no magnetic field extends through the casing 18 to outside of the eddy-current sensor 1. As a result, a majority of the magnetic field strength is directed towards the target 2, thus improving sensing capability for the same input AC signal compared to if the outer electrically conductive casing 18 were not provided.

It can be seen in Figure 5 that the magnetic field lines become more spaced out the further away from the electrically conductive coil 4 that they are, representing that the magnetic field at a point is weaker the further away from the coil 4 the point is, as is well known. The magnitude of the induced eddy currents, and therefore of the induced counteracting magnetic fields, is positively correlated with the strength of the magnetic field that induces the eddy currents, which as seen in Figure 5, increases closer to the electrically conductive coil 4.

The magnitude of the initial magnetic field 50 is correlated with the rate of change of the input signal applied to the coil 4, such that a higher frequency signal produces a stronger initial magnetic field 50.

If the electrically conductive coil 4 were directly adjacent to (i.e. in contact with) the electrically conductive casing 18 then for a high frequency AC input a strong magnetic field would be produced, in turn producing large eddy currents in the casing 18 and therefore inducing large counteracting magnetic fields. These large magnetic fields would be so strong as to significantly attenuate (or entirely cancel) the useful magnetic field produced by the electrically conductive coil 4 towards the electrically conductive target 2 and thereby make the eddy current sensor 1 much less effective at sensing.

According to the present disclosure, the electrically conductive casing 18 is separated from the electrically conductive coil 4 by the separator 16. By doing this, the magnetic field strength at the casing 20 is reduced by virtue of it being further away from the electrically conductive coil 4. Thus, for the same input signal, the induced eddy currents in the casing 18 will be lower, and therefore so too the counteracting magnetic fields produced by those eddy currents. This reduces the magnetic field attenuation caused by the eddy current and thereby reduces the performance drop that they cause, particularly at high frequencies.

The disclosed structure therefore advantageously focusses the magnetic field towards the target by virtue of the provided electrically conductive casing, whilst also avoiding significant performance drop due to this casing, particularly at high frequencies. This is achieved in a simple and low cost manner, since it does not require a laminated material for the casing (which is another possibility for reducing eddy currents) and it does not require a ferromagnetic material for the casing (which is more expensive), rather any electrically conductive material may be used, since the eddy currents produced in the electrically conductive casing provide the magnetic shielding function usually achieved by the ferromagnetic material.

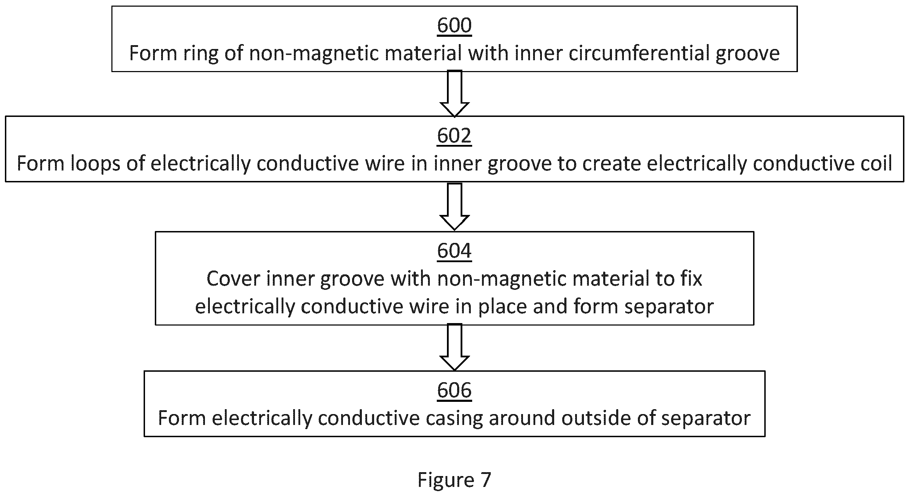

Figure 7 shows an example method of forming the eddy-current sensor shown in Figure 2.

In a first stage 600, a ring of non-magnetic material (i.e. a piece) is formed, having an inner groove (i.e. having a U-shaped profile). Next, at stage 602, turns of electrically conductive wire are formed inside the inner groove, i.e. wound into the inner groove, to create the electrically conductive coil 4.

Then, at stage 604, the inner groove, now containing the electrically conductive coil 4, is closed by placing more non-magnetic material over the opening of the groove. This produces a separator 16 having the shape seen in Figure 4, and seals the electrically conductive coil 4 in place within the separator.

Then, at stage 606, the electrically conductive casing 18 is arranged around the outside of the separator 16, to have the shape shown in Figure 4.

It will be appreciated that although in the example method the coil is wound inwards into the circumferential groove, alternatively it may be wound onto an outside surface of a cylinder of non-magnetic material (e.g. which may provide the inner separator portion), with the outer part of the separator being formed later instead of forming the part to cover the inner groove. Further alternatively, the coil may be wound separately and then later placed within the separator. However, it is particularly convenient that the electrically conductive coil is spooled around a part of the separator, i.e. that a part of the separator may be used for forming the electrically conductive coil.

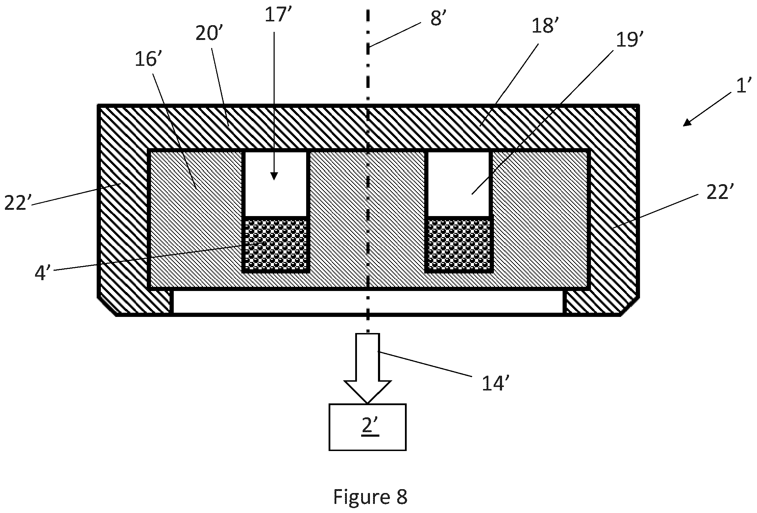

Figure 8 is a cross-sectional view showing an eddy-current sensor 1' according to a second example of the present disclosure. It operates based on the same principle as the first example, described above, and therefore its operation will not be described in detail again. Rather, only the differences between the sensor structures will be described.

The eddy-current sensor 1' is cylindrical about a central axis 8' and is arranged above an electrically conductive target 2'.

The eddy-current sensor 1' includes an electrically conductive coil 4', coiled symmetrically about the central axis 8', i.e. lying in a plane perpendicular to this central axis 8'. Driving the electrically conductive coil 4' with an alternating current produces a time-varying magnetic field, as described above, allowing sensing of the target 2'.

The electrically conductive target 2' is spaced from the electrically conductive coil 4' along a target spacing direction 14', which in this example is defined as a direction parallel to a vertical axis relative to the view of Figure 8, and towards the target 2'.

The coil 4' is accommodated within a separator 16' which is formed from a non-magnetic material. The separator 16' in this example is substantially cylindrical about the central axis 8' and is formed with a circular groove 17' (also referred to as a recess). This allows the coil 4' to be coiled directly onto or into this circular groove 17' during manufacture, for convenient manufacturing. A casing 18' is then arranged around the separator 16' to form the outer surface of the eddy-current sensor 1'. Additional material (e.g. the same as or different to the material of the separator 16') may be arranged within the groove 17' after the coil 4' is formed, to fix the coil in place.

Alternatively, as in the illustrated example, the casing 18' may be arranged over the separator 16' leaving an air gap 19' between the coil 4' and the back of the casing 18' (referred to below as the first portion). This enables a particularly straightforward manufacturing process and reduces the number of separate parts required to form the eddy-current sensor 1'.

The casing 18' is made of an electrically conductive material. It includes a first portion 20' which is positioned outwards of the coil 4' along the target spacing direction 14', i.e. on the opposite side of the electrically conductive coil 4' to the target 2'. The first portion is substantially circular (in the plane perpendicular to the central axis 8') and extends perpendicular to the target spacing direction 14'.

The casing 18' also includes a second portion 22'. The second portion 22' has the form of a cylinder, extending downwards from the first portion 20', parallel to the target spacing direction. Two parts of this second portion 22' are seen in the cross-section of Figure 8.

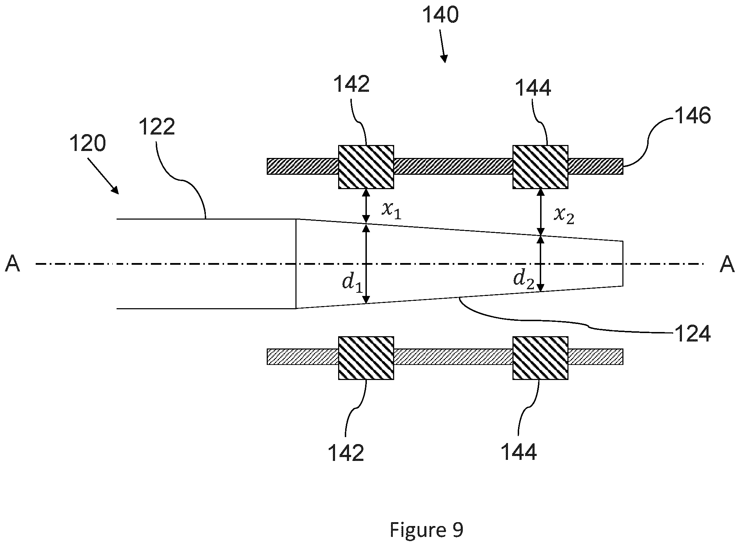

Figure 9 is a schematic diagram showing a cross-sectional view of a sensor apparatus 140 which uses two ring-shaped eddy-current sensors 142, 144, which are each the same as the ring-shaped eddy-current sensor 1 described in the first example. It will be appreciated that this is an exemplary embodiment, illustrating a possible use of the disclosed eddy-current sensor, but the use of the eddy-current is not limited thereto.

The eddy-current sensors 142, 144 are each mounted to a support member 146 and are arranged to sense the respective separation distances *x*₁, *x*₂ between the eddy-current sensor 142, 144 and a target, which in this example is provided by a target portion 124 of a transfer tube 120.

The transfer tube 120, which is this filled with a hydraulic fluid such as oil, is coupled to an actuator within a rotating hub of a propeller in such a way that the transfer tube 120 rotates coaxially with the propeller, and translates axially with varying pitch angle of the blades of the propeller. The transfer tube 120 comprises a main tubular portion 122, supported by a bearing (out of view beyond the left edge of Figure 2), and a target portion 124 mounted to, or integral with, an end of the transfer tube 120.

The transfer tube 120 has a varying diameter along its axial length. In this example the diameter tapers to a minimum value at the right-hand end of the transfer tube 120. Thus at a first exemplary position along the axis of rotation A the target portion 124 has a diameter *d*₁, and at a second exemplary position along the axis of rotation A the target 124 has a diameter *d*₂ which is smaller than *d*₁. Whilst the slope of the surface of the target portion 124 shown in Figure 9 is linear (i.e. frustoconical in shape), other examples may use other profiles where the diameter still changes monotonically with distance along the axis of rotation A (e.g. shaped like a trumpet bell).

Thus it can be seen that, as the transfer tube 120 moves along the rotational axis A, the first distance sensor 142 will measure a varying distance ***x*** to the outer surface of the target portion 124, and, due to the monotonicity of this relationship, for a given axial displacement of the transfer tube 120, the distance between the first distance sensor 142 and the outer surface of the target portion 124 represents a unique pitch angle of the blades of the propeller. The same applies to the measurements made by the second distance sensor 144. The tapering of the target portion 124 thus allows the axial movement of the target portion 124 along its axis of rotation A to be determined, and therefore allows the blade angle of the propeller blades to be determined.

In the example shown in Figure 9, the sensor apparatus 140 has two similar distance sensors 142, 144, arranged side by side. Other examples may have three or more sensors. Using two or more distance sensors to measure the distance to the surface of the target portion 124 allows two or more independent signals indicative of the distance to the target portion to be generated for improved accuracy and/or reliability (e.g. in case one sensor fails).

The improved sensitivity and reduced magnetic pollution provided by the eddy-current sensors of the present disclosure, as described above, may allow more accurate distance sensing to be achieved in the example of Figure 9, for example since magnetic interference between the two sensors 142, 144 is reduced.

It will be appreciated by those skilled in the art that the disclosure has been illustrated by describing one or more specific aspects thereof, but is not limited to these aspects; many variations and modifications are possible, within the scope of the accompanying claims.

## Claims

1. An eddy-current sensor comprising:
an electrically conductive coil, wherein the eddy-current sensor is arranged to sense a distance between the electrically conductive coil and an outer surface of an electrically conductive target, the electrically conductive target separated from the electrically conductive coil along a target spacing direction;
an electrically conductive casing; and
a separator formed from non-magnetic material;
wherein the separator is interposed between the electrically conductive coil and the electrically conductive casing; and
wherein the electrically conductive casing comprises a first portion, positioned outwards of the electrically conductive coil along the target spacing direction and extending perpendicular to the target spacing direction, and a second portion, extending from the first portion along the target spacing direction past at least part of the electrically conductive coil, so as to focus a magnetic field produced by the electrically conductive coil along the target spacing direction.

2. The eddy-current sensor of claim 1, wherein the target spacing direction is a radial direction of the electrically conductive coil, such that the eddy-current sensor is arranged to sense a distance between the electrically conductive coil and the outer surface of an electrically conductive target located within the electrically conductive coil.

3. The eddy-current sensor of claim 1 or 2, wherein the electrically conductive casing further comprises a third portion, extending from the first portion along the target spacing direction past at least part of the electrically conductive coil, on an opposite side of the electrically conductive coil to the second portion.

4. The eddy-current sensor of claim 1, wherein the target spacing direction is an axial direction of the electrically conductive coil, wherein the second portion is cylindrical and wherein the at least part of the electrically conductive coil is accommodated within the cylindrical second portion.

5. The eddy-current sensor of any preceding claim, wherein the electrically conductive casing is formed from non-ferromagnetic material.

6. The eddy-current sensor of any preceding claim, wherein the electrically conductive casing comprises aluminium.

7. The eddy-current sensor of any preceding claim, wherein the separator is interposed between the first portion of the electrically conductive casing and the electrically conductive coil.

8. The eddy-current sensor of any preceding claim, wherein the separator is interposed between the second portion of the electrically conductive casing and the electrically conductive coil.

9. The eddy-current sensor of any preceding claim, wherein the separator comprises an inner separator portion, positioned inwards of the electrically conductive coil along the target spacing direction.

10. The eddy-current sensor of any preceding claim wherein the electrically conductive coil is surrounded by the separator.

11. The eddy-current sensor of any preceding claim, wherein the separator comprises polymer material.

12. The eddy-current sensor of any preceding claim, wherein the thickness of the separator interposed between the electrically conductive coil and the electrically conductive casing is at least 3 mm.

13. The eddy-current sensor of any preceding claim, further comprising an oscillator arranged to supply alternating current to the electrically conductive coil.

14. The eddy-current sensor of claim 13, wherein the oscillator is arranged to supply alternating current to the electrically conductive coil having a frequency of at least 500 kHz.

15. A method of constructing an eddy-current sensor as claimed in any preceding claim, comprising:
forming a piece of non-magnetic material;
wrapping an electrically conductive wire onto the piece, to form the electrically conductive coil;
wherein the separator comprises the piece and wherein the method further comprises:
forming the electrically conductive casing around the separator and the electrically conductive coil, such that the separator is interposed between the electrically conductive coil and the electrically conductive casing.
